# EUROPEAN PATENT APPLICATION

(11) **EP 4 675 406 A1**
(43) Date of publication of application: **07.01.2026**
(21) Application number: 25170912.7
(22) Date of filing: 16.04.2025
(51) Int. Cl.: G06F 3/041, G06F 1/16, G06F 3/044, G06F 3/046

(54) **DISPLAY DEVICE AND ELECTRONIC DEVICE INCLUDING THE SAME**

(30) Priority: 05.07.2024 KR 20240088825; 07.08.2024 KR 20240105148
(71) Applicant: Samsung Display Co., Ltd., Yongin-si, Gyeonggi-do 17113 (KR)
(72) Inventor: Kim, Tae Chang, Giheung-gu, Yongin-si, Gyeonggi-do (KR); An, Sung Guk, Giheung-gu, Yongin-si, Gyeonggi-do (KR); Byeon, Min Seong, Giheung-gu, Yongin-si, Gyeonggi-do (KR)
(74) Representative: Dr. Weitzel & Partner

(57) **Abstract**

A display device includes: a display panel including an emission material layer and a touch sensor layer on the emission material layer and including a digitizer; and a panel support layer under the display panel, wherein the panel support layer includes: a first layer including a first fiber extending in a first direction, a second layer on the first layer and including a second fiber extending in a second direction different from the first direction, a third layer on the second layer and including the first fiber extending in the first direction, and a lower functional layer including a magnetic metal powder.

## Description

### BACKGROUND

### 1. Field

The present invention relates to a display device and an electronic device including the same.

### 2. Description of the Related Art

As the information-oriented society evolves, various demands for display devices are ever increasing. Display devices may be a liquid-crystal display device, a field emission display device, a light-emitting display device, or the like. Light-emitting display devices may include an organic light-emitting display device including organic light-emitting diodes as light-emitting elements, an inorganic light-emitting display device including inorganic light-emitting diodes as light-emitting elements, etc.

Recently, in order to increase portability of the display device and provide a wider display screen, a bendable display device in which the display area can be bent, or a foldable display device in which the display area can be folded is being released.

The above information disclosed in this Background section is only for enhancement of understanding of the background and therefore the information discussed in this Background section does not necessarily constitute prior art.

### SUMMARY

Aspects of some embodiments of the present invention include a display device with relatively reduced thickness.

Aspects of some embodiments of the present invention include a display device with excellent performance of blocking and absorbing electromagnetic waves given the thickness of the device.

It should be noted that characteristics of embodiments according to the present invention are not limited to the above-mentioned characteristics; and other characteristics of embodiments according to the present invention will be more apparent to those skilled in the art from the following descriptions.

The present invention is defined by the features of the independent claims. Preferred embodiments are disclosed in the dependent claims and the description.

According to some embodiments of the present invention, a display device includes, a display panel including an emission material layer and a touch sensor layer on the emission material layer and including a digitizer, and a panel support layer under the display panel, wherein the panel support layer includes, a first layer including first fiber extending in a first direction, a second layer on the first layer and including second fiber extending in a second direction different from the first direction, a third layer on the second layer and including the first fiber extending in the first direction, and a lower functional layer containing magnetic metal powder.

According to some embodiments, the lower functional layer is between the first layer and the second layer, between the second layer and the third layer, under the first layer, or on the third layer.

According to some embodiments, the panel support layer comprises, a folding portion and at least one non-folding portion on one side of the folding portion, and wherein the lower functional layer is arranged across the folding portion and the non-folding portion.

According to some embodiments, a thickness of the lower functional layer at the folding portion is equal to a thickness of the lower functional layer at the non-folding portion.

According to some embodiments, the folding portion comprises a lattice pattern, and wherein a ratio of a coefficient of an electromagnetic wave absorption performance of the panel support layer at the folding portion to a coefficient of an electromagnetic wave absorption performance of the panel support layer at the non-folding portion is equal to or greater than 40% when a hole area ratio is 50%.

According to some embodiments, the folding portion comprises a stripe pattern, and wherein a ratio of a coefficient of an electromagnetic wave absorption performance of the panel support layer at the folding portion to a coefficient of an electromagnetic wave absorption performance of the panel support layer at the non-folding portion is equal to or greater than 75% when a hole area ratio is 20%.

According to some embodiments, the first fiber and the second fiber are polymers each containing carbon fiber or glass fiber.

According to some embodiments, the touch sensor layer comprises a first sensing electrode configured to recognize an input by an input device, and a second sensing electrode configured to recognize a pressure by a user's touch.

According to some embodiments, the display device may further comprise, a third sensing electrode between the first sensing electrode and the second sensing electrode, wherein the third sensing electrode is a ground electrode.

According to some embodiments, the first sensing electrode and the second sensing electrode are spaced apart from each other with the third sensing electrode interposed therebetween, and wherein the first to third sensing electrodes are insulated from one another.

According to some embodiments of the present invention, a display device includes a folding area and at least one non-folding area located on one side of the folding area, the device including, a display panel including an emission material layer, and a touch sensor layer on the emission material layer and including a touch electrode and a pen electrode, and a panel support layer under the display panel and including a first layer and a second layer including fiber yarns extending in different directions, and an electromagnetic wave blocking layer in the folding area and the non-folding area.

According to some embodiments, the electromagnetic wave blocking layer is between the first layer and the second layer, under the first layer, or on the second layer.

According to some embodiments, the panel support layer further comprises, a third layer comprising fiber yarn extending in a different direction from the second layer, and wherein the first layer, the second layer and the third layer are stacked on one another in this order.

According to some embodiments, a thickness of the electromagnetic wave blocking layer at the folding area is equal to a thickness of the electromagnetic wave blocking layer at the non-folding area.

According to some embodiments, the panel support layer comprises a lattice pattern in the folding area, and wherein a ratio of a coefficient of absorption performance of the electromagnetic wave blocking layer at the folding area to a coefficient of absorption performance of the electromagnetic wave blocking layer at the non-folding area is equal to or greater than 40% when a hole area ratio is 50%.

According to some embodiments, the panel support layer comprises a stripe pattern in the folding area, and wherein a ratio of a coefficient of absorption performance of the electromagnetic wave blocking layer at the folding area to a coefficient of absorption performance of the electromagnetic wave blocking layer at the non-folding area is equal to or greater than 40% when a hole area ratio is 20%.

According to some embodiments, the fiber yarns are polymers each containing carbon fiber or glass fiber.

According to some embodiments, the pen electrode is configured to recognize an input by an input device, and the touch electrode is configured to recognize a pressure by a user's touch.

According to some embodiments, the display device may 18, further comprise, a ground electrode between the pen electrode and the touch electrode.

According to some embodiments, the pen electrode and the touch electrode are spaced apart from each other with the ground electrode interposed therebetween, and wherein the pen electrode, the touch electrode and the ground electrode are insulated from one another.

According to an aspect of the present invention, there is provided a display device including, a display panel including an emission material layer and a touch sensor layer on the emission material layer and including a digitizer, a window on a surface of the display panel, a lower protective film on an opposite surface of the display panel, and a panel support layer under the lower protective film, wherein the panel support layer includes, a first layer including first fiber extending in a first direction, a second layer on the first layer and including second fiber extending in a second direction different from the first direction, a third layer on the second layer and including the first fiber extending in the first direction, and a lower functional layer containing magnetic metal powder.

According to some embodiments, the display device may further comprise, an upper protective film on the window.

According to some embodiments, the lower functional layer is between the first layer and the second layer, between the second layer and the third layer, under the first layer, or on the third layer.

According to some embodiments, the panel support layer comprises, a folding portion and at least one non-folding portion on one side of the folding portion, and wherein the lower functional layer is arranged across the folding portion and the non-folding portion.

According to some embodiments, a thickness of the lower functional layer at the folding portion is equal to a thickness of the lower functional layer at the non-folding portion.

According to some embodiments, the folding portion comprises a lattice pattern, and wherein a ratio of a coefficient of an electromagnetic wave absorption performance of the panel support layer at the folding portion to a coefficient of an electromagnetic wave absorption performance of the panel support layer at the non-folding portion is equal to or greater than 40% when a hole area ratio is 50%.

According to some embodiments, the folding portion comprises a stripe pattern, and wherein a ratio of a coefficient of an electromagnetic wave absorption performance of the panel support layer at the folding portion to a coefficient of an electromagnetic wave absorption performance of the panel support layer at the non-folding portion is equal to or greater than 75% when a hole area ratio is 20%.

According to some embodiments of the present invention, it may be possible to relatively reduce the thickness of a display device.

According to some embodiments of the present invention, a display device can exhibit excellent performance of blocking and absorbing electromagnetic waves given the thickness of the device.

It should be noted that the characteristics of embodiments according to the present invention are not limited to those described above and other characteristics of embodiments according to the present invention will be more apparent to those skilled in the art from the following descriptions.

### BRIEF DESCRIPTION OF THE DRAWINGS

The above and other aspects and features of the present invention will become more apparent by describing in detail embodiments thereof with reference to the attached drawings, in which:
FIG. 1 is a perspective view showing a display device according to some embodiments of the present invention when it is unfolded.
FIG. 2 is a perspective view showing the display device according to some embodiments of the present invention when it is folded.
FIG. 3 is a perspective view showing a display device according to some embodiments of the present invention when it is unfolded.
FIG. 4 is a perspective view showing the display device according to some embodiments of the present invention when it is folded.
FIG. 5 is a cross-sectional view showing a display device according to some embodiments of the present invention.
FIG. 6 is a cross-sectional view showing an example of a display panel according to some embodiments of the present invention.
FIG. 7 is a plan view of a pressure sensor according to some embodiments of the present invention.
FIG. 8 is a view showing a sensing electrode according to some embodiments of the present invention.
FIG. 9 is a view showing the operation of a display device in a first frame according to some embodiments of the present invention.
FIG. 10 is a view showing the operation of the display device in a second frame according to some embodiments of the present invention.
FIG. 11 is a plan view showing an example of a panel support layer according to some embodiments.
FIG. 12 is a plan view showing another example of a panel support layer according to some embodiments.
FIG. 13 is a cross-sectional view showing an example of a panel support layer according to some embodiments.
FIG. 14 is a cross-sectional view showing another example of a panel support layer according to some embodiments.
FIG. 15 is a cross-sectional view showing a stack structure of a panel support layer according to some embodiments.
FIG. 16 is an exploded perspective view showing a panel support layer according to some embodiments.
FIG. 17 is an exploded perspective view showing a panel support layer according to some embodiments.
FIG. 18 is an exploded perspective view showing a panel support layer according to some embodiments.
FIG. 19 is an exploded perspective view showing a panel support layer according to some embodiments.

### DETAILED DESCRIPTION

The invention will now be described more fully hereinafter with reference to the accompanying drawings, in which aspects of some embodiments of the invention are shown. This invention may, however, be embodied in different forms and should not be construed as limited to the embodiments set forth herein. Rather, these embodiments are provided so that this disclosure will be thorough and complete, and will fully convey the scope of the invention to those skilled in the art.

It will also be understood that when a layer is referred to as being "on" another layer or substrate, it can be directly on the other layer or substrate, or intervening layers may also be present. The same reference numbers indicate the same components throughout the specification.

Hereinafter, aspects of some embodiments of the present invention will be described in more detail with reference to the accompanying drawings.

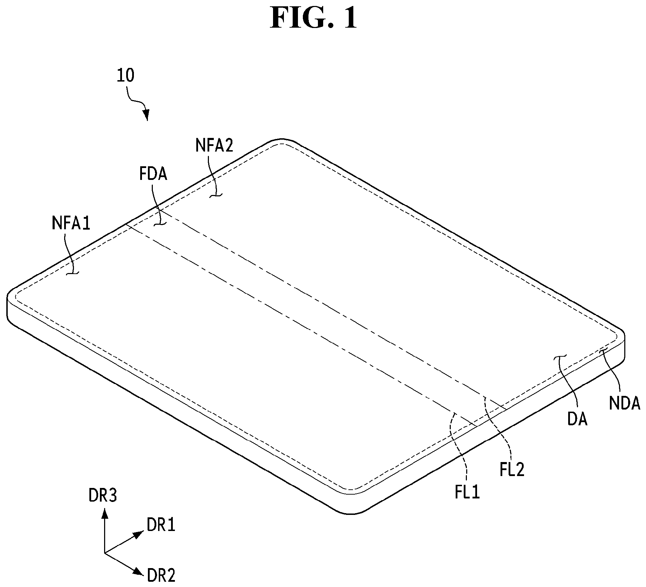

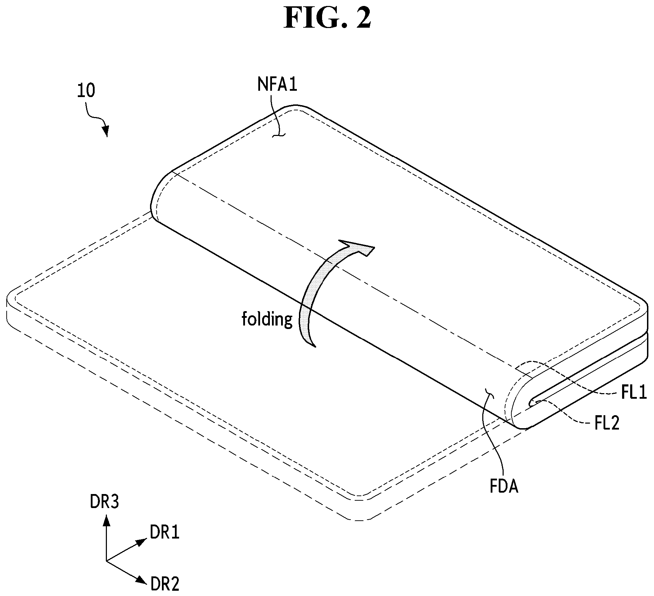

FIG. 1 is a perspective view showing a display device according to some embodiments of the present invention when the display device is in an unfolded state. FIG. 2 is a perspective view showing the display device according to some embodiments of the present invention when the display device is in a folded state.

Referring to FIGS. 1 and 2, FIG. 1 shows a first state in which the display device 10 is unfolded without being folded over the folding lines FL1 and FL2, and FIG. 2 shows a second state in which the display device 10 is folded over the folding lines FL1 and FL2.

According to some embodiments of the present invention, the display device 10 may be a foldable display device. According to some embodiments of the present invention, the display device 10 is applied to a smartphone. It should be understood, however, that the embodiments of the present invention are not limited thereto. For example, a display device 10 according to some embodiments of the present invention is for displaying moving images (e.g., video images) or still images (e.g., static images). The display device 1 may be used as the display screen of portable electronic devices such as a mobile phone, a smart phone, a tablet PC, a smart watch, a watch phone, a mobile communications terminal, an electronic notebook, an electronic book, a portable multimedia player (PMP), a navigation device and a ultra mobile PC (UMPC), as well as the display screen of various products such as a television, a notebook, a monitor, a billboard, and an Internet of Things device.

The display device 10 according to the embodiments may be variously classified by the way in which images are displayed. For example, the display device 10 may include an organic light-emitting display device, an inorganic light-emitting display device, a quantum-dot light-emitting display device, a micro LED display device, a nano LED display device, a field emission display device, an electrophoretic display device, etc. In the following description, an organic light-emitting display device will be described as an example of the display device, and the organic light-emitting display device will be simply referred to as a display device unless it is necessary to discern it from others. It is, however, to be understood that the embodiments of the present invention are not limited to the organic light-emitting display device, and one of the above-listed display devices or any other display device well known in the art may be employed without departing from the scope of the present invention.

In the drawings, the first direction DR1 may refer to a direction parallel to a side of the display device 10, for example, the horizontal direction of the display device 10 when viewed from the top (e.g., in a plan view). A second direction DR2 may refer to a direction parallel to another side of the display device 10 that meet the side of the display device 10, for example, the vertical direction of the display device 10 when viewed from the top (e.g., in a plan view). A third direction DR3 may refer to the thickness direction of the display device 10.

The first direction DR1 and the second direction DR2 may be horizontal directions and may intersect each other. For example, the first direction DR1 and the second direction DR2 may be perpendicular to each other. In addition, a third direction DR3 may intersect the first direction DR1 and the second direction DR2, and may be a vertical direction, for example. Herein, the side indicated by the arrow of each of the first to third directions DR1, DR2 and DR3 may be referred to as a first side, while the opposite side may be referred to as a second side unless specifically state otherwise. As used herein, the terms "on," "upper side," "above," "top" and "upper surface" refer to the side indicated by the arrow of the third direction D3 as shown in the drawings. The terms "under," "lower side," "below," "bottom" and "lower surface" refer to the opposite side indicated by the arrow of the third direction D3 as shown in the drawings.

The display device 10 may have a rectangular shape or a square shape when viewed from the top (e.g., in a plan view). It should be understood, however, that the embodiments of the present invention are not limited thereto. According to some embodiments, the display device 10 may have a rectangular shape with sharp corners or a rectangular shape with rounded corners when viewed from the top (e.g., in a plan view). The display device 10 may include two shorter sides extending in the first direction DR1 and two longer sides extending in the second direction DR2 when viewed from the top (e.g., in a plan view).

The display device 10 includes a display area DA and a non-display area NDA. The shape of the display area DA may conform to the shape of the display device 10 when viewed from the top (e.g., in a plan view). For example, when the display device 10 is rectangular when viewed from the top (e.g., in a plan view), the display area DA may also be rectangular.

The display area DA may include a plurality of pixels to display images. The plurality of pixels may be arranged in a matrix pattern. The plurality of pixels may be, but is not limited to, a rectangle, a diamond, or a square when viewed from the top (e.g., in a plan view). For example, the plurality of pixels may be a quadrangle other than a rectangle, a diamond or a rectangle, a polygon other than a quadrangle, a circle, or an ellipse when viewed from the top (e.g., in a plan view).

The non-display area NDA may not include pixels and thus may not display images. The non-display area NDA may be arranged around (e.g., in a periphery or outside a footprint of) the display area DA. The non-display area NDA may be arranged to surround the display area DA as shown in FIGS. 1 and 2, but embodiments according to the present invention are not limited thereto. The display area DA may be partially surrounded by the non-display area NDA.

The display device 10 may stay either in a first state when the display device 10 is unfolded or a second state when the display device 10 is folded. The display device 10 may be folded inward (in-folding manner) so that the display device DA is located inside, as shown in FIG. 2. When the display device 10 is folded in the in-folding manner, a part of the front surface of the display device 10 may face the other part of the front surface. Alternatively, the display device 10 may be folded outward (out-folding manner) so that the display area DA is located on the opposite sides and is located outside. When the display device 10 is folded in the out-folding manner, a part of the rear surface of the display device 10 may face the other part of the rear surface.

The display device 10 may include a folding area FDA, a first non-folding area NFA1, and a second non-folding area NFA2. The display device 10 can be bent or folded at the folding area FDA, while it cannot be bent or folded at the first non-folding area NFA1 and the second non-folding area NFA2. According to some embodiments, the first non-folding area NFA1 and the second non-folding area NFA2 may be flat areas of the display device 10. It should be understood, however, that the embodiments of the present invention are not limited thereto.

The first non-folding area NFA1 may be located on one side, for example, the left side of the folding area FDA. The second non-folding area NFA2 may be located on the opposite side, for example, the right side of the folding area FDA. Herein, the left side may refer to the second side in the first direction DR1, and the right side may refer to the first side in the first direction DR1.

The folding area FDA may be defined by the first folding line FL1 and the second folding line FL2, where the display device 10 can be bent with a curvature (e.g., a set or predetermined curvature). The first folding line FL1 may be the boundary between the folding area FDA and the first non-folding area NFA1, and the second folding line FL2 may be the boundary between the folding area FDA and the second non-folding area NFA2.

As shown in FIGS. 1 and 2, the first folding line FL1 and the second folding line FL2 may extend in the second direction DR2, and the display device 10 may be folded in the first direction DR1. Accordingly, the length of the display device 10 in the first direction DR1 can be reduced to half (or about half), so that the display device 10 is relatively easy to carry.

When the first folding line FL1 and the second folding line FL2 extend in the second direction DR2, the length of the folding area FDA in the second direction DR2 may be larger than the length in the first direction DR1. In addition, the length of the first non-folding area NFA1 in the second direction DR2 may be larger than the length of the first non-folding area NFA1 in the first direction DR1. The length of the second non-folding area NFA2 in the second direction DR2 may be larger than the length of the second non-folding area NFA2 in the first direction DR1.

Each of the display area DA and the non-display area NDA may overlap at least one of the folding area FDA, the first non-folding area NFA1, or the second non-folding area NFA2. In the example shown in FIGS. 1 and 2, each of the display area DA and the non-display area NDA overlaps the folding area FDA, the first non-folding area NFA1 and the second non-folding area NFA2.

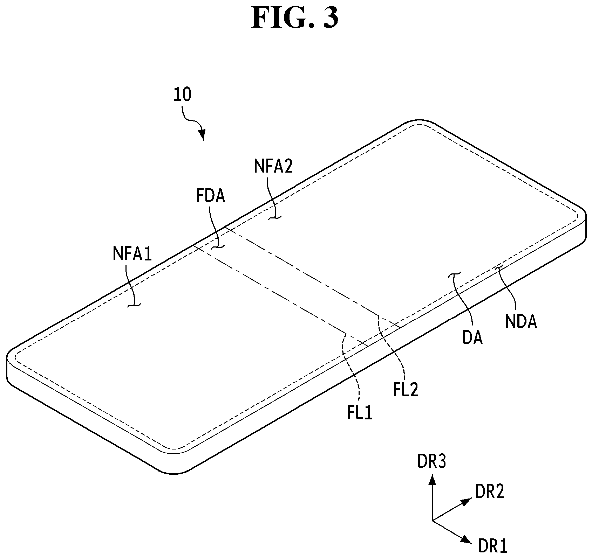

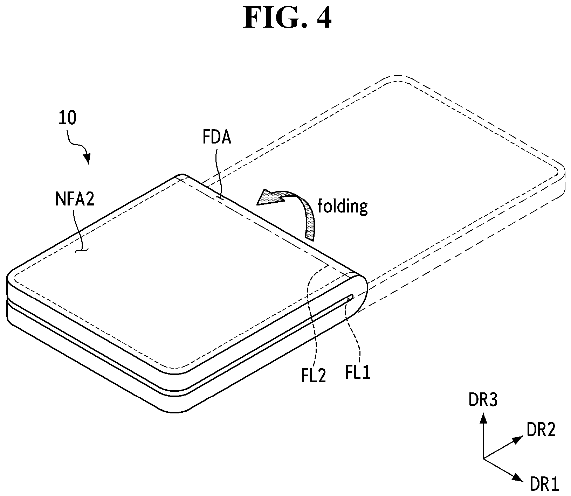

FIG. 3 is a perspective view showing a display device according to some embodiments of the present invention when the display device is in an unfolded state. FIG. 4 is a perspective view showing the display device according to some embodiments of the present invention when the display device is in a folded state.

Referring to FIGS. 3 and 4, FIG. 3 shows a first state in which the display device 10 is unfolded without being folded over the folding lines FL1 and FL2, and FIG. 4 shows a second state in which the display device 10 is folded over the folding lines FL1 and FL2.

In the first state in which the display device 10 is unfolded, the longer sides of the display device 10 may extend in the second direction DR2, and the shorter sides of the display device 10 may extend in the first direction DR1.

In the display device 10 according to the embodiments shown in FIGS. 3 and 4, the first folding line FL1 and the second folding line FL2 may extend in the first direction DR1, and the display device 10 may be folded along the second direction DR2.

The first non-folding area NFA1 may be located on one side, for example, the lower side of the folding area FDA. The second non-folding area NFA2 may be located on the opposite side, for example, the upper side of the folding area FDA. Herein, the upper side may refer to the second side in the second direction DR2, and the lower side may refer to the first side in the second direction DR2.

As shown in FIGS. 3 and 4, when the first folding line FL1 and the second folding line FL2 extend in the first direction DR1, the length of the folding area FDA in the first direction DR1 may be larger than the length in the second direction DR2. In addition, the length of the first non-folding area NFA1 in the second direction DR2 may be larger than the length of the first non-folding area NFA1 in the first direction DR1. The length of the second non-folding area NFA2 in the second direction DR2 may be larger than the length of the second non-folding area NFA2 in the first direction DR1.

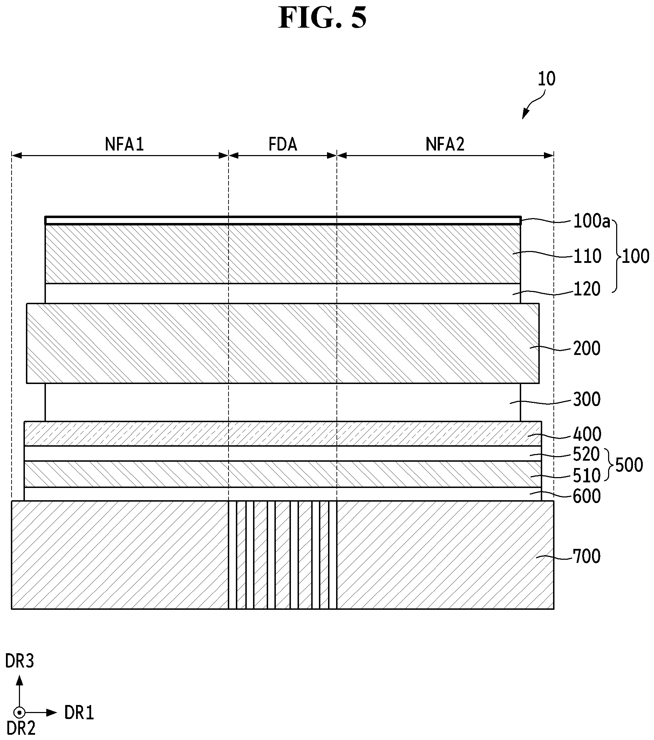

FIG. 5 is a cross-sectional view showing a display device according to some embodiments of the present invention.

Referring to FIG. 5, the display device 10 according to some embodiments may include an upper protective film 100, a window 200, a second adhesive layer 300, a display panel 400, a lower protective film 500, a fourth adhesive layer 600, and a panel support layer 700.

The display panel 400 may be a panel for displaying images. The display panel 400 may be an organic light-emitting display panel including an organic light-emitting layer, a quantum-dot light-emitting display panel including a quantum-dot light-emitting layer, an inorganic light-emitting display panel using an inorganic semiconductor element as a light-emitting element, and a micro light-emitting display panel using a micro light-emitting diode as a light-emitting element. In the following description, an organic light-emitting display panel is employed as the display panel 400. It is, however, to be understood that embodiments according to the present invention are not limited thereto.

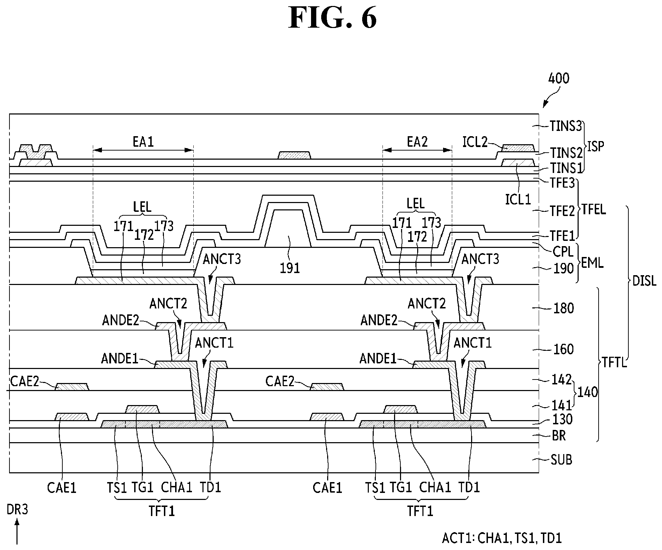

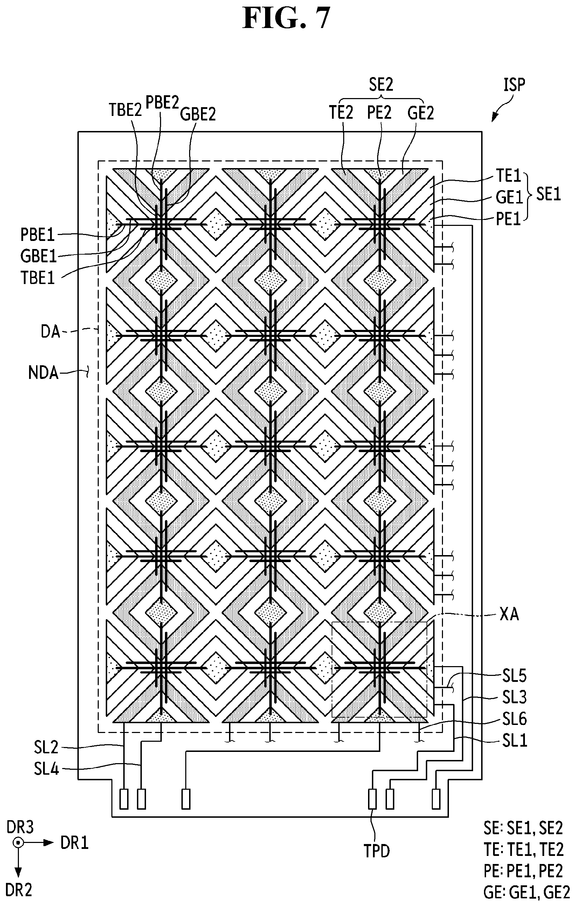

According to some embodiments, the display panel 400 of the display device 10 may include a touch sensor layer ISP (see FIG. 6) with a built-in digitizer. For example, the touch sensor layer ISP (see FIG. 6) of the display panel 400 may not only recognize an input by a user's touch (e.g., an input by a touch using a part of the body), but may also recognize an input of an input means such as a pen (e.g., an input using electromagnetic interaction) because the digitizer is built-in. The touch sensor layer ISP will be described later with reference to FIG. 7, etc.

The window 200 may be located on a surface of the display panel 400. For example, the window 200 may be located on the upper surface of the display panel 400. The window 200 can protect the display panel 400 from external shock. The window 200 can enhance the impact resistance of the display device 10. For example, the touch sensor layer ISP (see FIG. 6) of the display panel 400 with the digitizer built therein is located at the relatively upper position of the display device 10 and accordingly may be vulnerable to external shock. The window 200 can protect the touch sensor layer ISP (see FIG. 6) of the display panel 400.

The window 200 may be made of a transparent material. For example, the window 200 may be made of glass or plastic. According to some embodiments, the window 200 may be ultra thin glass (UTG) having a thickness of 0.1 mm or less. Alternatively, the window 200 may be a transparent polyimide film.

The second adhesive layer 300 may be located under the window 200. For example, the second adhesive layer 300 may be located between the window 200 and the display panel 400. The window 200 and the display panel 400 may be coupled with each other by the second adhesive layer 300. The second adhesive layer 300 may include a transparent adhesive such as a pressure sensitive adhesive (PSA) and an optically clear adhesive (OCA). Alternatively, the second adhesive layer 300 may include an acrylic adhesive material.

The upper protective film 100 may be located on the window 200. The upper protective film 100 may include an upper protective layer 110, a coating film 100a, and a first adhesive layer 120.

The upper protective layer 110 may perform at least one functions of: shock absorption, anti-scratch, anti-fingerprint, anti-glare, and anti-scattering when the window 200 is broken. The upper protective layer 110 may include a material that is highly flexible and scratch-resistant. For example, the upper protective layer 110 may be a polymer film such as polyethylene terephthalate or a tempered glass film.

The coating film 100a may be located on the upper protective layer 110. For example, the coating film 100a may be located on the upper surface of the upper protective layer 110. The coating film 100a may be a low-reflection and anti-fingerprint (LRAF) coating film.

The first adhesive layer 120 may be located under the upper protective layer 110. For example, the first adhesive layer 120 may be located between the upper protective layer 110 and the window 200. The upper protective layer 110 and the window 200 may be coupled with each other by the first adhesive layer 120. The first adhesive layer 120 may include a transparent adhesive such as a pressure sensitive adhesive (PSA) and an optically clear adhesive (OCA). Alternatively, the first adhesive layer 120 may include an acrylic adhesive material.

The first adhesive layer 120 may be handled after being attached to the upper protective layer 110 during the storage, transportation, etc., of the upper protective film 100. Before the first adhesive layer 120 is attached to the window 200, a release film may be located on the lower surface of the first adhesive layer 120. The release film may be attached to the lower surface of the first adhesive layer 120 when handling the upper protective film 100 and may be removed when the first adhesive layer 120 is attached to the window 200.

The lower protective film 500 may be located on the opposite surface of the display panel 400. For example, the lower protective film 500 may be located on the lower surface of the display panel 400. The lower protective film 500 may include a lower protective layer 510 and a third adhesive layer 520.

The lower protective layer 510 may support the display panel 400 and protect the opposite surface of the display panel 400. According to some embodiments, the lower protective layer 510 may be plastic, such as polyethylene terephthalate (PET) and polyimide.

The third adhesive layer 520 may be located on the lower protective layer 510. For example, the third adhesive layer 520 may be located between the lower protective layer 510 and the display panel 400. The lower protective layer 510 and the display panel 400 may be coupled with each other by the third adhesive layer 520. The third adhesive layer 520 may include a transparent adhesive such as a pressure sensitive adhesive (PSA) and an optically clear adhesive (OCA). Alternatively, the third adhesive layer 520 may include an acrylic adhesive material.

The third adhesive layer 520 may be handled after being attached to the lower protective layer 510 during the storage, transportation, etc., of the lower protective film 500. Before the third adhesive layer 520 is attached to the display panel 400, a release film may be located on the upper surface of the third adhesive layer 520. The release film may be attached to the upper surface of the third adhesive layer 520 when handling the lower protective film 500 and may be removed when the third adhesive layer 520 is attached to the display panel 400.

The panel support layer 700 may be located under the lower protective film 500. The panel support layer 700 may be a rigid member that does not easily change shape or volume due to external pressure. The panel support layer 700 is located on the opposite surface of the display panel 400 and is a rigid member that does not easily change its shape or volume due to external pressure, and thus it can support the display panel 400.

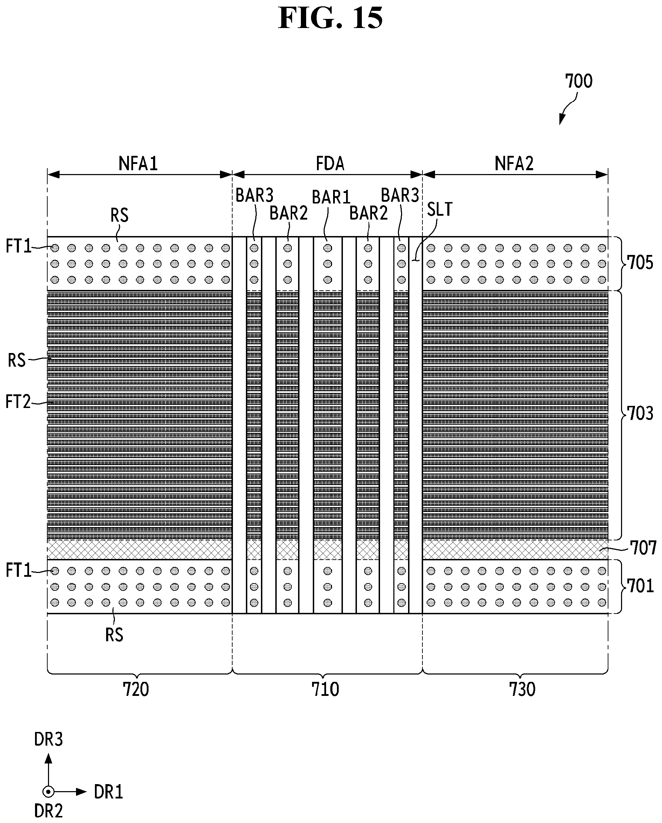

The panel support layer 700 may be a polymer containing carbon fiber or glass fiber. The panel support layer 700 may have a stack structure of polymer containing carbon fiber or glass fiber. According to some embodiments, because the panel support layer 700 includes the stack structure, a lower functional layer 707 (see FIG. 15) described later may be incorporated into the panel support layer 700. Accordingly, the thickness of the display device 10 can be relatively reduced, and electromagnetic waves can be blocked and absorbed more effectively. The lower functional layer 707 (see FIG. 15) will be described later with reference to FIG. 15, etc.

The panel support layer 700 may include a lattice pattern located on the folding area FDA so that it can be relatively easily bent in the folding area FDA. As the panel support layer 700 includes the lattice pattern located in the folding area FDA, the panel support layer 700 can be easily bent when the display device 10 is folded.

According to some embodiments, the panel support layer 700 of the display device 10 may include an active control pattern as the lattice pattern. Accordingly, the stress applied to the folding area FDA when the display device 10 is folded can be relatively reduced, and creases in the folding area FDA can be suppressed.

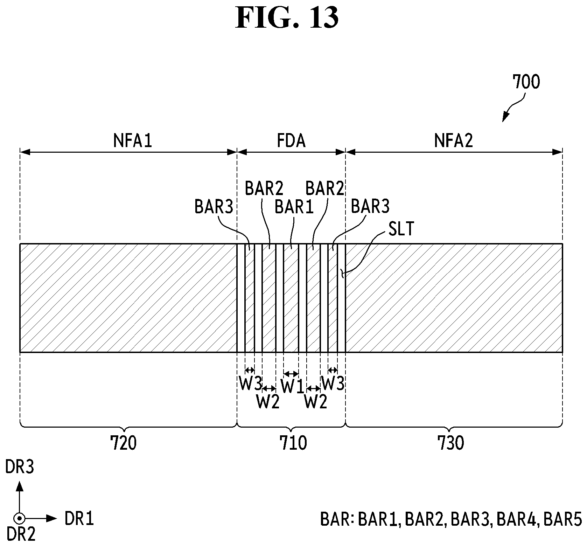

The active control pattern will be described in more detail later with reference to FIG. 13, etc.

The fourth adhesive layer 600 may be located on the panel support layer 700. For example, the fourth adhesive layer 600 may be located between the panel support layer 700 and the lower protective film 500. The panel support layer 700 and the lower protective film 500 may be coupled with each other by the fourth adhesive layer 600. The fourth adhesive layer 600 may include a transparent adhesive such as a pressure sensitive adhesive (PSA) and an optically clear adhesive (OCA). Alternatively, the fourth adhesive layer 600 may include an acrylic adhesive material.

FIG. 6 is a cross-sectional view showing an example of a display panel according to some embodiments of the present invention.

Referring to FIG. 6, the display panel 400 may include a substrate SUB, a display layer DISL, and a touch sensor layer ISP. The display layer DISL may include a thin-film transistor layer TFTL, an emission material layer EML, and an encapsulation layer TFEL.

The substrate SUB may be made of an insulating material such as a polymer resin. For example, the substrate SUB may be made of polyimide. The substrate SUB may be a flexible substrate that can be bent, folded, or rolled.

The thin-film transistor layer TFTL may be located on the substrate SUB. The thin-film transistor layer TFTL may include a barrier layer BR, a thin-film transistor TFT1, a first capacitor electrode CAE1, a second capacitor electrode CAE2, a first anode connection electrode ANDE1, a second anode connection electrode ANDE2, a gate insulator 130, a first interlayer dielectric film 141, a second interlayer dielectric film 142, a first planarization film 160, a second planarization film 180.

The barrier film BR may be located on the substrate SUB. The barrier film BR is a film for protecting the thin-film transistors of the thin-film transistor layer TFTL and an emissive layer 172 of the emission material layer EML. The barrier film BR may be made up of multiple inorganic films stacked on one another alternately. For example, the barrier film BR may be made up of multiple layers in which one or more inorganic layers of a silicon nitride layer, a silicon oxynitride layer, a silicon oxide layer, a titanium oxide layer and an aluminum oxide layer are alternately stacked on one another.

The thin-film transistors TFT1 may be located on the barrier film BR. An active layer ACT1 of the thin-film transistor TFT1 may be located on the barrier layer BR. The active layer ACT1 of the thin-film transistor TFT1 may include polycrystalline silicon, monocrystalline silicon, low-temperature polycrystalline silicon, amorphous silicon, or an oxide semiconductor.

The active layer ACT1 may include a channel region CHA1, a source region TS1 and a drain region TD1. The channel region CHA1 may overlap with a gate electrode TG1 in the third direction DR3 that is the thickness direction of the substrate SUB. The source region TS1 may be located on one side of the channel region CHA1, and the drain region TD1 may be located on the opposite side of the channel region CHA1. The source region TS1 and the drain region TD1 may not overlap with the gate electrode TG1 in the third direction DR3. The source region TS1 and the drain region TD1 may be formed by doping a silicon semiconductor or an oxide semiconductor with ions or impurities to have conductivity.

The gate insulator 130 may be located on the active layer ACT1 of the thin-film transistor TFT1. The gate insulator 130 may be formed of an inorganic layer, for example, a silicon nitride layer, a silicon oxynitride layer, a silicon oxide layer, a titanium oxide layer, or an aluminum oxide layer.

The gate electrode TG1 of the thin-film transistor TFT1 and the first capacitor electrode CAE1 may be located on the gate insulator 130. The gate electrode TG1 may overlap with the channel region CHA1 in the third direction DR3. Although the gate electrode TG1 and the first capacitor electrode CAE1 are spaced apart from each other in the example shown in FIG. 7, the gate electrode TG1 and the first capacitor electrode CAE1 may be connected with each other as a single piece. The gate electrode TG1 and the first capacitor electrode CAE1 may be made up of a single layer or multiple layers of one of molybdenum (Mo), aluminum (Al), chromium (Cr), gold (Au), titanium (Ti), nickel (Ni), neodymium (Nd) and copper (Cu) or an alloy thereof.

The first interlayer dielectric film 141 may be located on the gate electrode TG1 of the thin-film transistor TFT1 and the first capacitor electrode CAE1. The first interlayer dielectric film 141 may be formed of an inorganic layer, for example, a silicon nitride layer, a silicon oxynitride layer, a silicon oxide layer, a titanium oxide layer, or an aluminum oxide layer. The first interlayer dielectric film 141 may be made of a plurality of inorganic films.

The second capacitor electrode CAE2 may be located on the first interlayer dielectric layer 141. The second capacitor electrode CAE2 may overlap the first capacitor electrode CAE1 of the thin-film transistor TFT1 in the third direction DR3. In addition, when the gate electrode TG1 and the first capacitor electrode CAE1 are formed as a single piece, the second capacitor electrode CAE2 may overlap the gate electrode TG1 in the third direction DR3. Because the first interlayer dielectric layer 141 has a dielectric constant (e.g., a set or predetermined dielectric constant), a capacitor can be formed by the first capacitor electrode CAE1, the second capacitor electrode CAE2 and the first interlayer dielectric layer 141 located therebetween. The second capacitor electrode CAE2 may be made up of a single layer or multiple layers of one of molybdenum (Mo), aluminum (Al), chromium (Cr), gold (Au), titanium (Ti), nickel (Ni), neodymium (Nd) and copper (Cu) or an alloy thereof.

A second interlayer dielectric film 142 may be arranged over the second capacitor electrode CAE2. The second interlayer dielectric film 142 may be formed of an inorganic layer, for example, a silicon nitride layer, a silicon oxynitride layer, a silicon oxide layer, a titanium oxide layer, or an aluminum oxide layer. The second interlayer dielectric film 142 may be made of a plurality of inorganic films.

The first interlayer dielectric film 141 and the second interlayer dielectric film 142 may be included in the interlayer dielectric film 140.

A first anode connection electrode ANDE1 may be located on the second interlayer dielectric film 142. The first anode connection electrode ANDE1 may be connected to the drain electrode DT1 of the thin-film transistor TFT1 through a first connection contact hole ANCT1 that penetrates the gate insulator 130, the first interlayer dielectric film 141 and the second interlayer dielectric film 142. The first anode connection electrode ANDE1 may be made up of a single layer or multiple layers of one of molybdenum (Mo), aluminum (Al), chromium (Cr), gold (Au), titanium (Ti), nickel (Ni), neodymium (Nd) and copper (Cu) or an alloy thereof.

A first planarization film 160 may be located over the first anode connection electrode ANDE1 for providing a flat surface over level differences due to the thin-film transistor TFT1. The first planarization film 160 may be formed of an organic layer such as an acryl resin, an epoxy resin, a phenolic resin, a polyamide resin and a polyimide resin.

A second anode connection electrode ANDE2 may be located on the first planarization film 160. The second anode connection electrode ANDE2 may be connected to the first anode connection electrode ANDE1 through a second connection contact hole ANCT2 penetrating the first planarization film 160. The second anode connection electrode ANDE2 may be made up of a single layer or multiple layers of one of molybdenum (Mo), aluminum (Al), chromium (Cr), gold (Au), titanium (Ti), nickel (Ni), neodymium (Nd) and copper (Cu) or an alloy thereof.

A second planarization film 180 may be located on the second anode connection electrode ANDE2. The second planarization film 180 may be formed as an organic layer such as an acryl resin, an epoxy resin, a phenolic resin, a polyamide resin and a polyimide resin.

An emission material layer EML including light-emitting elements LEL and a bank 190 may be located on the second planarization film 180. Each of the light-emitting elements LEL includes a pixel electrode 171, an emissive layer 172, and a common electrode 173.

The pixel electrode 171 may be located on the second planarization film 180. The pixel electrode 171 may be connected to the second anode connection electrode ANDE2 through a third connection contact hole ANCT3 penetrating the second planarization film 180.

In the top-emission structure in which light exits from the emissive layer 172 toward the common electrode 173, the pixel electrode 171 may be made of a metal material having a high reflectivity such as a stack structure of aluminum and titanium (Ti / Al / Ti), a stack structure of aluminum (Al) and ITO (Indium Tin Oxide) (ITO/ Al /ITO), an APC alloy and a stack structure of an APC alloy and ITO (ITO / APC / ITO). The APC alloy is an alloy of silver (Ag), palladium (Pd) and copper (Cu).

The bank 190 may partition the pixel electrode 171 on the second planarization film 180 to define a first emission area EA1 and a second emission area EA2. The bank 190 may be arranged to cover the edges of the pixel electrode 171. The bank 190 may be formed of an organic film such as an acryl resin, an epoxy resin, a phenolic resin, a polyamide resin and a polyimide resin.

In each of the first emission area EA1 and the second emission area EA2, the pixel electrode 171, the emissive layer 172 and the common electrode 173 are stacked on one another sequentially, so that holes from the pixel electrode 171 and electrons from the common electrode 173 are recombined with each other in the emissive layer 172 to emit light.

The emissive layer 172 may be located on the pixel electrode 171 and the bank 190. The emissive layer 172 may include an organic material to emit light of a certain color. For example, the emissive layer 172 may include a hole transporting layer, an organic material layer, and an electron transporting layer.

The common electrode 173 may be located on the emissive layer 172. The common electrode 173 may be arranged to cover the emissive layer 172. The common electrode 173 may be a common layer formed commonly across the first emission area EA1 and the second emission area EA2.

In the top-emission organic light-emitting diode, the common electrode 173 may be formed of a transparent conductive material (TCP) such as ITO and IZO that can transmit light, or a semi-transmissive conductive material such as magnesium (Mg), silver (Ag) and an alloy of magnesium (Mg) and silver (Ag). When the common electrode 173 is formed of a semi-transmissive metal material, the light extraction efficiency can be increased by using microcavities.

A spacer 191 may be located on the bank 190. The spacer 191 may support a mask during a process of fabricating the emission layer 172. The spacer 191 may be formed of an organic layer such as an acryl resin, an epoxy resin, a phenolic resin, a polyamide resin and a polyimide resin.

According to some embodiments of the present invention, the display panel 400 may further include a capping layer CPL located on the common electrode 173. The capping layer CPL may be made of an inorganic material. For example, the capping layer CPL may include at least one of: silicon nitride, aluminum nitride, zirconium nitride, titanium nitride, hafnium nitride, tantalum nitride, silicon oxide, aluminum oxide, titanium oxide, tin oxide, cerium oxide, or silicon oxynitride.

An encapsulation layer TFEL may be located on the common electrode 173. The encapsulation layer TFEL may include at least one inorganic layer to prevent or reduce permeation of contaminants such as oxygen or moisture into the emission material layer EML. In addition, the encapsulation layer TFEL may include at least one organic film to protect the emission material layer EML from particles such as dust. For example, the encapsulation layer TFEL may include a first inorganic encapsulation layer TFE1, an organic encapsulation layer TFE2 and a second inorganic encapsulation layer TFE3.

The first inorganic encapsulation film TFE1 may be located on the common electrode 173, the organic encapsulation film TFE2 may be located on the first inorganic encapsulation film TFE1, and the second inorganic encapsulation film TFE3 may be located on the organic encapsulation film TFE2. The first inorganic encapsulation film TFE1 and the second inorganic encapsulation film TFE3 may be made up of multiple layers in which one or more inorganic layers of a silicon nitride layer, a silicon oxynitride layer, a silicon oxide layer, a titanium oxide layer and an aluminum oxide layer are alternately stacked on one another. The organic encapsulation film TFE2 may be an organic film such as an acryl resin, an epoxy resin, a phenolic resin, a polyamide resin, a polyimide resin, etc.

The touch sensor layer ISP may be located on the encapsulation layer TFEL. The touch sensor layer ISP may be incorporated into the display panel 400 via continuous processes. The touch sensor layer ISP may include a first touch insulating film TINS1, a first conductive layer ICL1, a second touch insulating film TINS2, a second conductive layer ICL2, and a third touch insulating film TINS3.

The first touch insulating film TINS1 may be located on the encapsulation layer TFEL. The first touch insulating film TINS1 may be formed of an inorganic film, for example, a silicon nitride layer, a silicon oxynitride layer, a silicon oxide layer, a titanium oxide layer, or an aluminum oxide layer.

A first conductive layer ICL1 may be located on the first touch insulating film TINS1. The first conductive layer ICL1 may be made up of a single layer or multiple layers of one of molybdenum (Mo), aluminum (Al), chromium (Cr), gold (Au), titanium (Ti), nickel (Ni), neodymium (Nd) and copper (Cu) or an alloy thereof.

The second touch insulating film TINS2 may be located on the first conductive layer ICL1. The second touch insulating layer TINS2 may be formed of an inorganic layer, for example, a silicon nitride layer, a silicon oxynitride layer, a silicon oxide layer, a titanium oxide layer, or an aluminum oxide layer. Alternatively, the second touch insulating layer TINS2 may be formed of an organic layer such as an acryl resin, an epoxy resin, a phenolic resin, a polyamide resin and a polyimide resin.

The second conductive layer ICL2 may be located on the second touch insulating film TINS2. The second conductive layer ICL2 may be made up of a single layer or multiple layers of one of molybdenum (Mo), aluminum (Al), chromium (Cr), gold (Au), titanium (Ti), nickel (Ni), neodymium (Nd) and copper (Cu) or an alloy thereof.

A third touch insulating film TINS3 is formed on the second conductive layer ICL2. The third touch insulating film TINS3 may provide a flat surface over the electrodes of the second conductive layer ICL2 having different heights. The third touch insulating film TINS3 may be formed of an organic layer such as an acryl resin, an epoxy resin, a phenolic resin, a polyamide resin and a polyimide resin.

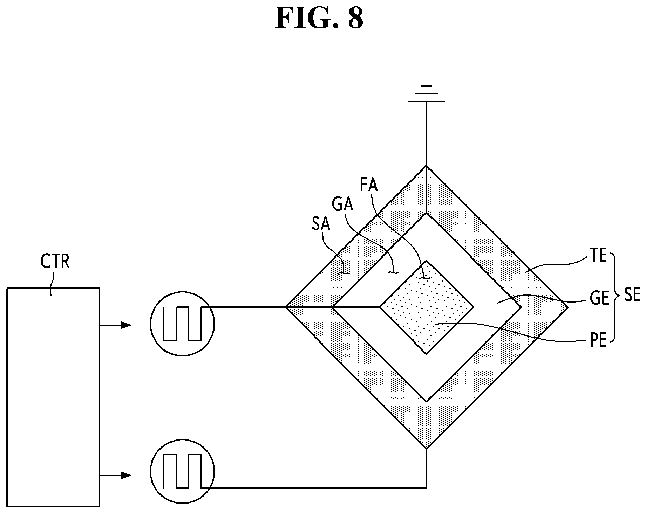

FIG. 7 is a plan view of a pressure sensor according to some embodiments of the present invention. FIG. 8 is a view showing a sensing electrode according to some embodiments of the present invention.

Referring to FIGS. 7 and 8 in conjunction with FIG. 6, the touch sensor layer ISP of the display device 10 according to some embodiments may include a digitizer. In other words, a digitizer function may be incorporated into the touch sensor layer ISP. For example, the touch sensor layer ISP may not only recognize an input by a user's touch (e.g., an input by a touch using a part of the body), but may also recognize an input by an input device such as a pen (e.g., an input using electromagnetic interaction) because the digitizer is incorporated into it.

The touch sensor layer ISP may include a plurality of sensing electrodes SE. The plurality of sensing electrodes SE may be located in the display area DA. The touch sensor layer ISP may include touch pads TPD and a plurality of signal lines SL1, SL2, SL3, SL4, SL5 and SL6. The touch pads TPD and the plurality of signal lines SL1, SL2, SL3, SL4, SL5 and SL6 may be arranged in the non-display area NDA.

The plurality of sensing electrodes SE may include a first sensing electrode SE1 and a second sensing electrode SE2. A plurality of first sensing electrodes SE1 may extend in the first direction DR1. The plurality of first sensing electrodes SE1 may be electrically connected with one another. A plurality of second sensing electrodes SE2 may be arranged in the second direction DR2 intersecting the first direction DR1. The plurality of second sensing electrodes SE2 may be electrically connected with one another. The first sensing electrodes SE1 and the second sensing electrodes SE2 may be electrically insulated from each other.

Each of the plurality of sensing electrodes SE may include a pen electrode PE and a touch electrode TE. The pen electrode PE may be an electrode that senses an input by an input device such as a pen. The touch electrode TE may be an electrode that senses a user's touch.

As shown in FIG. 8, the pen electrode PE may be located in a first area FA defined in each of the sensing electrodes SE, and the touch electrode TE may be located in a second area SA. The first area FA may be surrounded by the second area SA. The first area FA may be a closed area surrounded by the second area SA.

A third area GA may be located between the first area FA and the second area SA. The first area FA, the second area SA and the third area GA are not limited to those shown in the drawings, and they may have different areas. The third area GA may be located between the first area FA and the second area SA. The third area GA may separate the first area FA from the second area SA.

Each of the plurality of sensing electrodes SE may further include a ground electrode GE. The ground electrode GE may be located in the third area GA. The ground electrode GE may be electrically grounded. The ground electrode GE may be located between the pen electrode PE and the touch electrode TE, and can relatively reduce signal interference between a signal of the pen electrode PE and a signal of the touch electrode TE. According to some embodiments, each of the plurality of sensing electrodes SE may include a separate insulating film that insulates between the pen electrode PE and the touch electrode TE instead of the ground electrode GE.

As shown in FIG. 7, each of the plurality of first sensing electrodes SE1 may include a first pen electrode PE1, a first ground electrode GE1 and a first touch electrode TE1, and each of the plurality of second sensing electrodes SE2 may include a second pen electrode PE2, a second ground electrode GE2 and a second touch electrode TE2.

The touch sensor layer ISP may include a plurality of bridge electrodes connecting between the plurality of sensing electrodes SE. The bridge electrodes may include pen bridge electrodes PBE1 and PBE2 connecting between adjacent ones of the pen electrodes PE, touch bridge electrodes TBE1 and TBE2 connecting between adjacent ones of the plurality of touch electrodes TE, and ground bridge electrodes GBE1 and GBE2 connecting between adjacent ones of the plurality of ground electrodes GE.

The pen bridge electrodes may include a first pen bridge electrode PBE1 connecting between adjacent ones of the plurality of first pen electrodes PE1, and a second pen bridge electrode PBE2 connecting between adjacent ones of the plurality of second pen electrodes PE2.

The touch bridge electrodes may include a first touch bridge electrode TBE1 connecting between adjacent ones of the plurality of first touch electrodes TE1, and a second touch bridge electrode TBE2 connecting between adjacent ones of the plurality of second touch electrodes TE2.

The ground bridge electrodes may include a first ground bridge electrode GBE1 connecting between adjacent ones of the plurality of first ground electrodes GE1, and a second ground bridge electrode GBE2 connecting between adjacent ones of the plurality of second ground electrodes GE2.

The first pen bridge electrode PBE1, the first touch bridge electrode TBE1 and the first ground bridge electrode GBE1 may be located in a different layer from that of the second pen bridge electrode PBE2, the second touch bridge electrode TBE2 and the second ground bridge electrode GBE2.

A plurality of signal lines SL1, SL2, SL3, SL4, SL5 and SL6 may electrically connect the plurality of sensing electrodes SE with the sensor controller CTR through the touch pads TPD or may be grounded.

For example, a first signal line SL1 may connect a first touch electrode TE1 with the sensor controller CTR through a touch pad TPD. A second signal line SL2 may connect a second touch electrode TE2 with the sensor controller CTR through a touch pad TPD. A third signal line SL3 may connect a first pen electrode PE1 with the sensor controller CTR through a touch pad TPD. A fourth signal line SL4 may connect a second pen electrode PE2 with the sensor controller CTR through a touch pad TPD. The fifth signal line SL5 may be connected to the first ground electrode GE1. The sixth signal line SL6 may be connected to the second ground electrode GE2.

The sensor controller CTR may be included in the display device 10 separately from the touch sensor layer ISP. For example, the sensor controller CTR may be mounted on the display panel 400 of the display device 10 in the form of a driver chip.

The sensor controller CTR may be a control device that controls the driving of the touch sensor layer ISP. The sensor controller CTR may drive the touch sensor layer ISP to simultaneously sense input by a user's touch and input by an input device.

For example, the sensor controller CTR may transmit an uplink signal to an input device and receive a downlink signal from the input device in order to sense an input by the input device. The uplink signal may be a signal that the sensor controller CTR provides to the input device in order to sense the proximity of the input device. The downlink signal may be a signal that the input device provides to the sensor controller CTR in order to provide data about pen data, position information of the input device, inclination of the input device, status information, etc. In addition, the sensor controller CTR may apply voltage to the sensing electrodes SE and sense changes in capacitance of the sensing electrodes SE in order to sense an input by a user's touch.

According to some embodiments, as shown in FIG. 8, signals having different phases may be applied from the sensor controller CTR to the touch electrode TE and the pen electrode PE. An in-phase signal may be applied to the touch electrode TE as a sensing signal, and an anti-phase signal may be applied to the pen electrode PE as a compensation signal. The anti-phase signal of the touch electrode TE may compensate for the in-phase signal of the pen electrode PE. The anti-phase signal of the touch electrode TE may relatively reduce noise between the touch electrode TE and the pen electrode PE that occurs while an in-phase uplink signal of the pen electrode PE is provided to the input device. The ground electrode GE may be separated from the touch electrode TE and the pen electrode PE, and a ground signal may be applied to it.

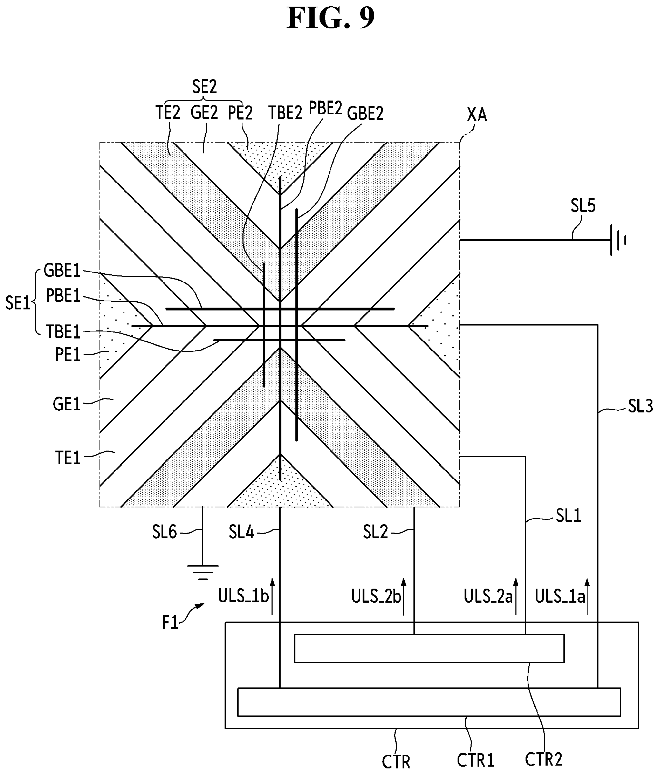

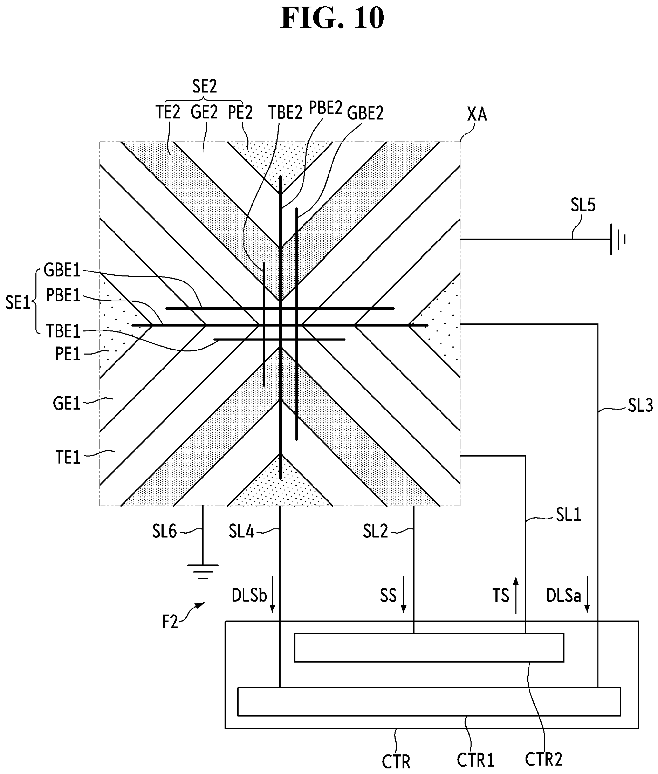

FIG. 9 is a view showing the operation of a display device in a first frame according to some embodiments of the present invention. FIG. 10 is a view showing the operation of the display device in a second frame according to some embodiments of the present invention.

Referring to FIGS. 9 and 10 in conjunction with FIGS. 7 and 8, the display device 10 may recognize an input by an input device during a first frame F1 in an operation period, and may sense an input by the input device and an input by a user's touch during a second frame F2. The sensor controller CTR may be connected to a plurality of sensing electrodes SE of the touch sensor layer ISP and may sense an input by a user's touch and an input by an input device.

As shown in FIG. 9, the sensor controller CTR may apply uplink signals ULS_1a, ULS_1b, ULS_2a and ULS_2b to the plurality of sensing electrodes SE during the first frame F1. The plurality of sensing electrodes SE may recognize the input device approaching the touch sensor layer ISP through the uplink signals ULS_1a, ULS_1b, ULS_2a and ULS_2b. Once the input device is recognized, the touch sensor layer ISP and the input device may be synchronized or paired.

As shown in FIG. 10, when the touch sensor layer ISP and the input device are paired, the input device may apply downlink signal DLSa and DLSb to the sensor controller CTR through the plurality of sensing electrodes SE during the second frame F2. The sensor controller CTR may sense the input by the input device based on the downlink signals DLSa and DLSb.

The uplink signals ULS_1a, ULS_1b, ULS_2a and ULS_2b may include first signals ULS_1a and ULS_1b and second signals ULS_2a and ULS_2b. The first signals ULS_1a and ULS_1b may be applied to the pen electrode PE, and the second signals ULS_2a and ULS_2b may be applied to the touch electrode TE.

The sensor controller CTR may apply the first signals ULS_1a and ULS_1b to the first pen electrode PE1 and the second pen electrode PE2, respectively. The sensor controller CTR may apply the second signals ULS_2a and ULS_2b to the first touch electrode PE1 and the second touch electrode PE2, respectively.

The first signals ULS_1a and ULS_1b may be uplink signals provided to the input device. The second signals ULS_2a and ULS_2b may be compensation signals for relatively improving noise generated between the touch electrode TE and the pen electrode PE during the communications of the input device with the first signals ULS_1a and ULS_1b. The second signals ULS_2a and ULS_2b may be anti-phase signals of the first signals ULS_1a and ULS_1b. In other words, the first signals ULS_1a and ULS_1b and the second signals ULS_2a and ULS_2b may have anti-phases.

As shown in FIG. 10, the sensor controller CTR may sense an input by a user's touch through the plurality of sensing electrodes SE. The sensor controller CTR may sense an external input by sensing changes in the mutual capacitance formed between the first touch electrode TE1 and the second touch electrode TE2.

During the second frame F2, the sensor controller CTR may provide a driving signal TS to the first touch electrode TE1. The sensor controller CTR may receive a sensing signal RS from the second touch electrode TE2. Accordingly, the sensor controller CTR may compare the driving signal TS with the respective sensing signal RS, and sense an input by a user's touch based on the amount of changes.

The sensor controller CTR may receive the downlink signals DLSa and DLSb from the input device through the first pen electrode PE1 and the second pen electrode PE2 during the second frame F2. The sensor controller CTR may determine coordinates of the input device based on the first downlink signal DLSa and the second downlink signal DLSb.

The sensor controller CTR may be connected to the pen electrode PE and the touch electrode TE, and may drive the pen electrode PE and the touch electrode TE independently of each other.

According to some embodiments of the present invention, as shown in FIGS. 9 and 10, the sensor controller CTR may include an input device controller CTR1 and a touch controller CTR2. The input device controller CTR1 and the touch controller CTR2 may be independently driven to drive the pen electrode PE and the touch electrode TE, respectively. The input device controller CTR1 may be connected to the pen electrode PE, and the touch controller CTR2 may be connected to the touch electrode TE.

The sensor controller CTR can simultaneously drive the pen electrode PE that senses the input by the input device and the touch electrode TE that senses the input by the user's touch during the second frame F2 by virtue of the input device controller CTR1 and the touch controller CTR2 that operate independently in different frequency bands. Therefore, high-speed operation at a frequency of 240 Hz or higher may be possible.

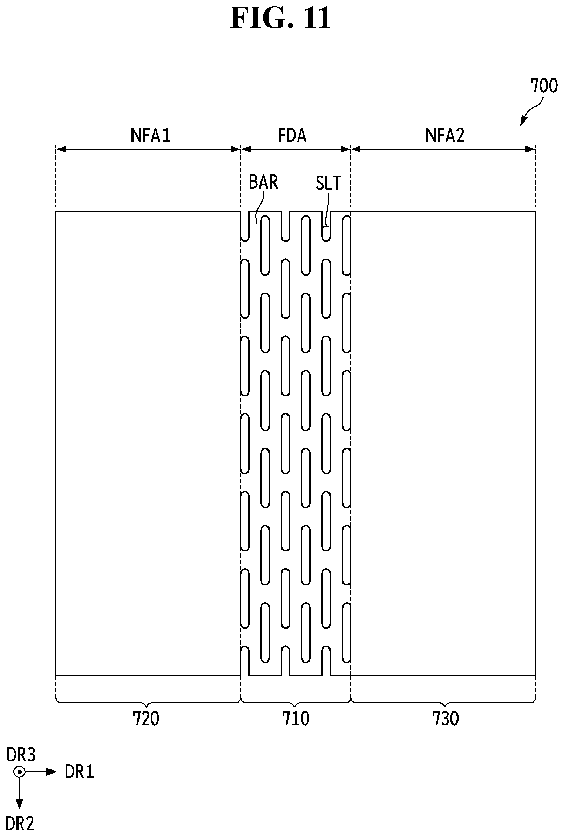

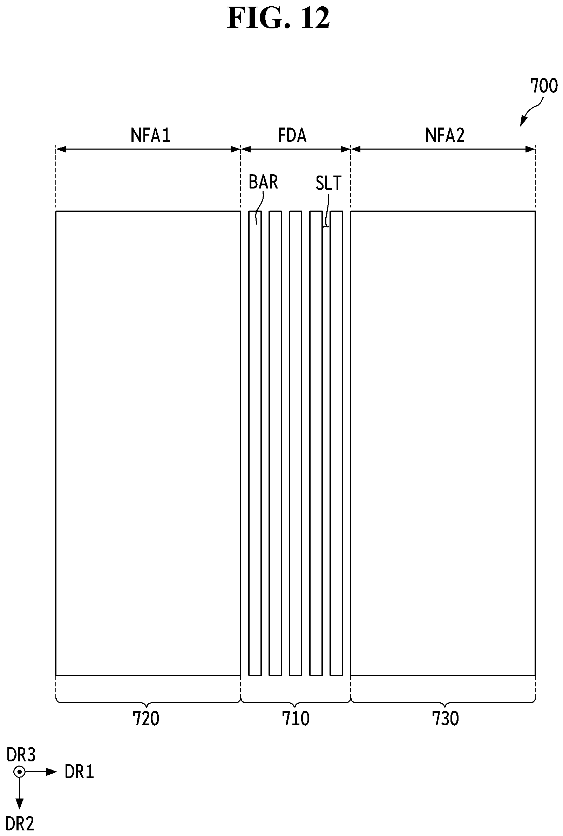

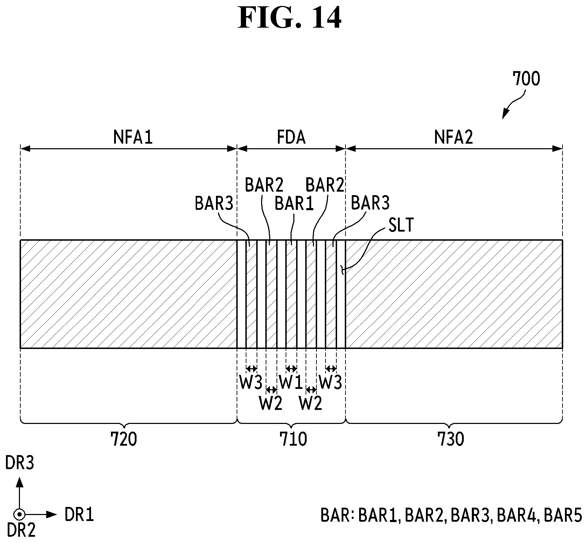

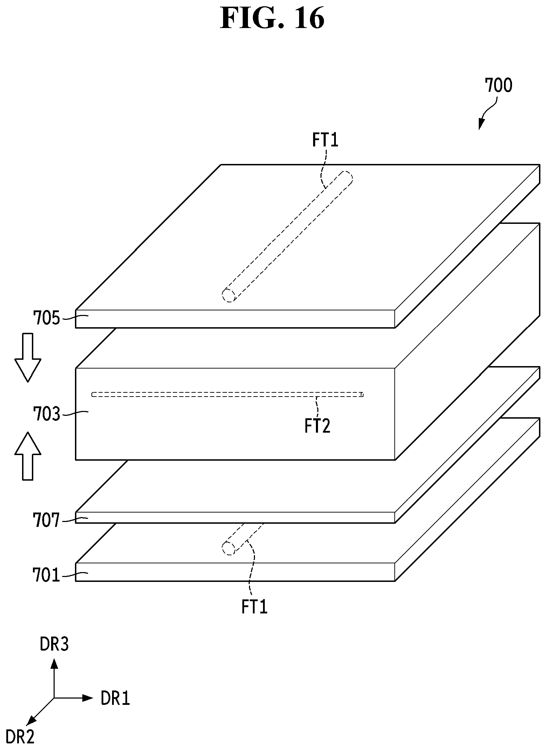

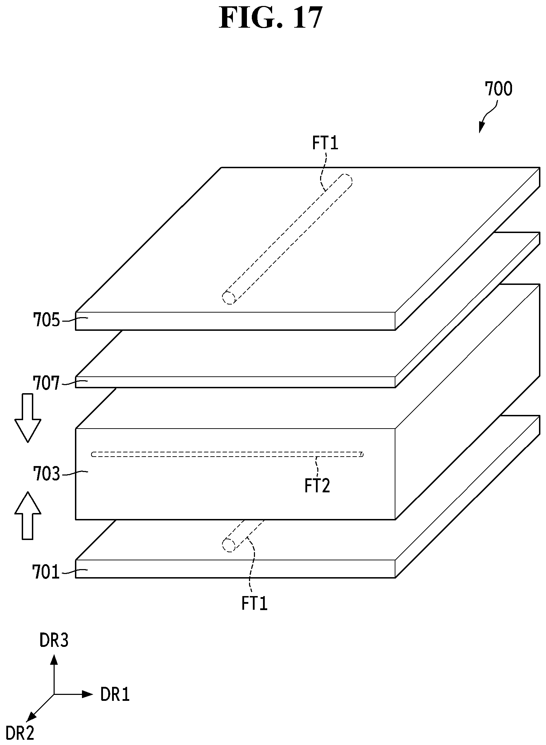

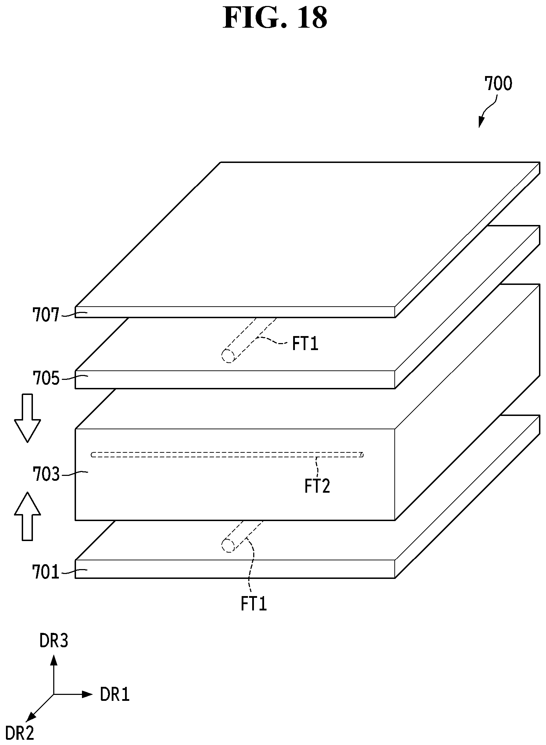

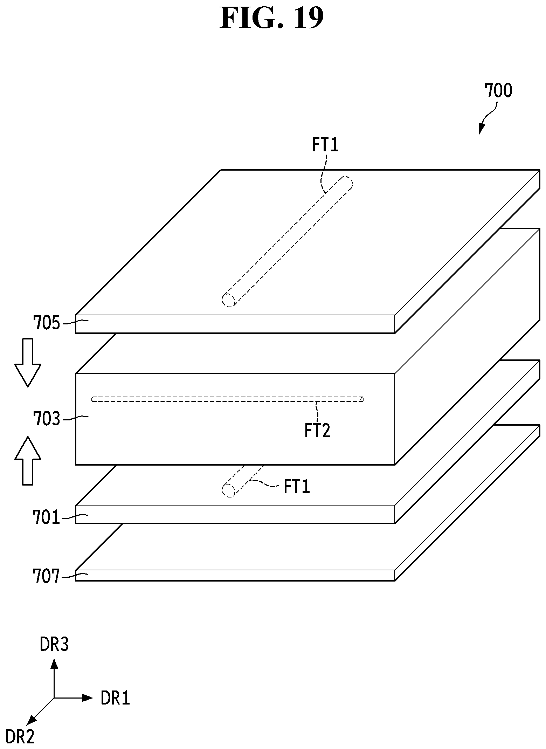

FIG. 11 is a plan view showing an example of a panel support layer according to some embodiments. FIG. 12 is a plan view showing another example of a panel support layer according to some embodiments. FIG. 13 is a cross-sectional view showing an example of a panel support layer according to some embodiments. FIG. 14 is a cross-sectional view showing another example of a panel support layer according to some embodiments. FIG. 15 is a cross-sectional view showing a stack structure of a panel support layer according to some embodiments. FIG. 16 is an exploded perspective view showing a panel support layer according to some embodiments. FIG. 17 is an exploded perspective view showing a panel support layer according to some embodiments. FIG. 18 is an exploded perspective view showing a panel support layer according to some embodiments. FIG. 19 is an exploded perspective view showing a panel support layer according to some embodiments.

Referring to FIGS. 11 to 19, the panel support layer 700 may include a folding portion 710, a first non-folding portion 720 and a second non-folding portion 730. The folding portion 710 may be located in the folding area FDA, the first non-folding portion 720 may be located in the first non-folding area NFA1, and the second non-folding portion 730 may be located in the second non-folding area NFA2.

The first non-folding portion 720 and the second non-folding portion 730 may not be folded when the display device 10 is folded. The first non-folding portion 720 may be located on the second side of the folding portion 710 in the first direction DR1, and the second non-folding portion 730 may be located on the first side of the folding portion 710 in the first direction DR1.

The folding portion 710 may be folded when the display device 10 is folded. The folding portion 710 may be located between the first non-folding portion 720 and the second non-folding portion 730 in the first direction DR1.

The folding portion 710 may include a lattice pattern. For example, the folding portion 710 may include a plurality of bars BAR, and a plurality of slits SLT located between the plurality of bars BAR.

According to some embodiments, as shown in FIG. 11, the folding portion 710 may have a lattice pattern structure. For example, the plurality of slits SLT may have a shape extending in the second direction DR2, and the plurality of slits SLT may be spaced apart from one another in the first direction DR1 and the second direction DR2. The plurality of slits SLT may be shifted in the second direction DR2 relative to the slits SLT located in adjacent columns in the first direction DR1. For example, the slits SLT located in the odd-numbered columns may be shifted in the second direction DR2 relative to the slits SLT located in the even-numbered columns. The slits SLT located in the odd-numbered columns may be arranged in parallel in the first direction DR1, and the slits SLT located in the even-numbered columns may be arranged in parallel in the first direction DR1.

According to some embodiments, as shown in FIG. 12, the folding portion 710 may have a stripe pattern structure. For example, in the folding portion 710, the plurality of bars BAR and the plurality of slits SLT may have a shape extending in the second direction DR2 and may be arranged alternately in the first direction DR1.

Although the embodiments of FIG. 12 will be described as an example, it is to be understood that the present invention is not limited thereto. Although five bars are shown in FIG. 12, the present invention is not limited thereto. The number of the bars may vary in various ways.

The plurality of bars BAR may include a first bar BAR1, a second bar BAR2 and a third bar BAR3. The first bar BAR1 may be located at the center (or approximately at the center) of the folding area FDA. The second bars BAR2 may be located on one side and the other side of the first bar BAR1, respectively. The third bars BAR3 may be located on one side and the other side of the second bar BAR2, respectively.

According to some embodiments, as shown in FIG. 14, the panel support layer 700 of the display device 10 may include an active control pattern as the lattice pattern. In the active control pattern, the width of the plurality of bars BAR may become narrower from the center of the folding portion 710 toward the edges, i.e., toward the non-folding portions 720 and 730.

For example, the width W1 of the first bar BAR1 may be greater than the width W2 of the adjacent second bars BAR2, and the width W2 of the second bars BAR2 may be greater than the width W3 of the adjacent third bars BAR3. Accordingly, the rigidity of the first bar BAR1 may be greater than the rigidity of the second bars BAR2, and the rigidity of the second bars BAR2 may be greater than the rigidity of the third bars BAR3.

According to some embodiments, the panel support layer 700 of the display device 10 includes the active control pattern, so that the stress applied to the folding area FDA when the display device 10 is folded can be relatively reduced, and creases in the folding area FDA can be relatively suppressed or prevented.

For example, the folding stress applied to the center of the folding portion 710 with the largest rotation radius when the display device 10 is folded may be greater than the folding stress applied to the edges of the folding portion 710.

In the active control pattern, the width W1 of the first bar BAR1 is the largest, and thus the rigidity of the first bar BAR is the largest, so that the folding stress applied to the center of the folding portion 710 can be relatively reduced.

It should be understood, however, that the embodiments of the present invention are not limited thereto. According to some embodiments, as shown in FIG. 14, the width W1 of the first bar BAR1, the width W2 of the second bars BAR2 and the width W3 of the third bars BAR3 may be all equal.

As shown in FIG. 15, the panel support layer 700 may be a fiber-reinforced plastic including fiber yarn and a base resin RS. The fiber yarn may be dispersed in the base resin RS. The fiber yarn may be carbon fiber containing carbon and may include graphene. The base resin RS may be an epoxy resin, a polyester resin, a polyamide resin, a polycarbonate resin, a polypropylene resin, a polybutylene resin, a polyacrylate resin, or a vinyl ester resin.

The panel support layer 700 may include a first layer 701, a second layer 703 located on the first layer 701, and a third layer 705 located on the second layer 703.

The base resin RS may be located in each of the first layer 701, the second layer 703 and the third layer 705. A portion of the base resin RS located in the first layer 701 may be referred to as a first base resin, a portion of the base resin RS located in the second layer 703 may be referred to as a second base resin, and a portion of the base resin RS located in the third layer 705 may be referred to as a third base resin.

The fiber yarn is made of carbon fiber and may have a cylindrical shape with a circular cross-section. The fiber yarn may include first fiber yarn FT1 and second fiber yarn FT2 having different diameters, different elastic moduli, or different carbon contents.

As shown in FIG. 16, the first fiber yarn FT1 may be located in the first layer 701 and the third layer 705 of the panel support layer 700, and the second fiber yarn FT2 may be located in the second layer 703 of the panel support layer 700. In other words, the same type of fiber yarn may be located in the first layer 701 and the third layer 705 as the first fiber yarn FT1, and a difference type of fiber yarn from that of the first layer 701 and the third layer 703 may be located in the second layer 703 as the second fiber yarn FT2.

For example, the first layer 701 may be prepreg comprised of first fiber yarns FT1 extending parallel (or generally parallel) in the second direction DR2 and a portion of the base resin RS surrounding them. The second layer 703 may be prepreg comprised of second fiber yarns FT2 extending generally parallel in the first direction DR1 and a portion of the base resin RS surrounding them. The third layer 705 may be prepreg comprised of first fiber yarns FT1 extending generally parallel in the second direction DR2 and a portion of the base resin RS surrounding them. As used herein, prepreg is a pre-impregnated material, meaning a material that is pre-impregnated with reinforced fiber and a resin.

As used herein, the expression "extending generally parallel in the first direction DR1" may mean "extending completely parallel in the first direction DR1" or "extending slightly intersecting the second direction DR2 to form an angle of 15° (or approximately 15°) or less." The expression "extending generally parallel in the second direction DR2" may mean "extending completely parallel in the second direction DR2" or "extending slightly intersecting the first direction DR1 to form an angle of 15° (or approximately 15°) or less."

Because the direction in which the first fiber yarn FT1 located in the first layer 701 extends is generally parallel to the second direction DR2, and the second direction DR2 is parallel to the folding lines FL1 and FL2 shown in FIGS. 1 and 2, the first layer 701 and the third layer 705 can be easily folded when the display device 10 is switched from the first state to the second state. However, if the panel support layer 700 includes only the first fiber yarn FT1, the panel support layer 700 may be bent or curved in the first direction DR1. For example, if the panel support layer 700 includes only the first fiber yarn FT1, the flatness and rigidity of the panel support layer 700 may be low.

For this reason, the panel support layer 700 may further include the second layer 703 having the second fiber yarn FT2 extending generally in the first direction DR1, so that it may be possible to prevent or reduce instances of the panel support layer 700 being bent or curved in the first direction DR1, and also to increase or relatively improve the rigidity of the panel support layer 700.

According to some embodiments, given the required rigidity of the panel support layer 700, the content of the second fiber yarn FT2 may be greater than the content of the first fiber yarn FT1 in the panel support layer 700. For example, the width of the second layer 703 of the panel support layer 700 in the third direction DR3 may be larger than the width of the first layer 701 in the third direction DR3 and the width of the third layer 705 in the third direction DR3. The width of the first layer 701 in the third direction DR3 may be equal to the width of the third layer 705 in the third direction DR3. It should be understood, however, that the embodiments of the present invention are not limited thereto.

As described above, by arranging a fiber yarn extending in a direction in each layer, it may be possible to prevent the thickness of each layer from becoming thicker. For example, if both the first fiber yarn FT1 and the second fiber yarn FT2 are located in one layer of the panel support layer 700, there may be an intersection of the first fiber yarn FT1 and the second fiber yarn FT2, and thus the thickness of the layer itself may increase. Accordingly, by arranging the fiber yarn extending in only one direction in each layer, it may be possible to reduce the thickness of the layer itself while providing the rigidity required for the panel support layer 700.

The panel support layer 700 may further include a lower functional layer 707. The lower functional layer 707 can block and absorb electromagnetic waves. The lower functional layer 707 may be an electromagnetic wave blocking layer or an electromagnetic wave absorbing layer. The lower functional layer 707 may include a magnetic metal powder (MMP) containing magnetic particles as an electromagnetic wave blocking or absorbing body.

The lower functional layer 707 may be located between the first to third layers 701, 703 and 705, on the first layer 701, or on the third layer 705. For example, as shown in FIG. 16, the lower functional layer 707 may be located between the first layer 701 and the second layer 703. Alternatively, as shown in FIG. 17, the lower functional layer 707 may be located between the second layer 703 and the third layer 705. Alternatively, as shown in FIG. 18, the lower functional layer 707 may be located on the third layer 705. Alternatively, as shown in FIG. 19, the lower functional layer 707 may be located under the first layer 701.

According to some embodiments, the thickness of the display device 10 can be relatively reduced by mounting the lower functional layer 707 in the panel support layer 700. For example, as the lower functional layer 707 is incorporated into the panel support layer 700 instead of being separately provided under the panel support layer 700, the distance from the display panel 400 including the digitizer can be shortened, so that electromagnetic waves can be more effectively blocked and absorbed. Accordingly, the thickness of the lower functional layer 707 can be relatively reduced, and in turn the thickness of the display device 10 can be relatively reduced.

In addition, the process can be simplified and the cost can be saved during the process of fabricating the panel support layer 700, compared to a process of attaching a module including a separated lower functional layer, e.g., a process of attaching a lower functional layer along with first to third layers.

According to some embodiments, the lower functional layer 707 may be located in the folding area FDA as well as the non-folding areas NFA1 and NFA2. The thickness of the lower functional layer 707 may be substantially constant across the folding area FDA and the non-folding areas NFA1 and NFA2.

In the display device 10 according to some embodiments, as the lower functional layer 707 is incorporated into the panel support layer 700, the foldability of the display device 10 and the electromagnetic wave absorption performance can be relatively improved.

**Table 1**

| | Comparative Example | First Embodiment | Second Embodiment |
|---|---|---|---|
| Electromagnetic Wave Absorption Performance at Non-folding portion | 4603 | 4310 | 4208 |
| Electromagnetic Wave Absorption Performance at Folding portion | 1028 | 1860 | 3282 |
| Uniformity of Electromagnetic Wave Absorption Performance | 23% | 43% | 78% |

Specifically, Table 1 above shows the electromagnetic wave absorption performance and uniformity of display devices according to Comparative Example, a first embodiment, and a second embodiment. The electromagnetic wave absorption performance is proportional to the product of the magnetic permeability and the thickness of a material. The magnetic permeability is a value indicating how much a material is magnetized for a given magnetic field. The values of the electromagnetic wave absorption performance shown in Table 1 above are not absolute values but relative values, as coefficients of performance.

In the display device according to Comparative Example, a panel support layer may not include the lower functional layer, and a separate electromagnetic wave absorbing layer may be included under the panel support layer. In this instance, in order to relatively improve the foldability at the folding area of the display device according to Comparative Example, an electromagnetic wave absorbing layer thinner than the non-folding areas and may be included. In addition, the electromagnetic wave absorbing layer may not be located at a part of the folding area, and the first electromagnetic wave absorbing layer and the second electromagnetic wave absorbing layer, which are respectively located in the first non-folding area and the second non-folding area, may be spaced apart from each other in the folding area. As a result, electromagnetic waves may move through the thin portion of the folding area or the portion where the electromagnetic wave absorbing layers are spaced apart from each other, and thus electromagnetic wave absorption performance may be relatively low at the folding area.

In contrast, in the display devices 10 according to the first and second embodiments, the lower functional layer 707 is incorporated into the panel support layer 700, and thus the thickness can be relatively reduced and the foldability can be relatively improved. Accordingly, the lower functional layer 707 having substantially the same thickness as that of the non-folding areas NFA1 and NFA2 may be located in the folding area FDA without any gap. Accordingly, the electromagnetic wave absorption performance can be relatively improved at the folding area FDA, and the uniformity of the electromagnetic wave absorption performance between the non-folding areas NFA and the folding area FDA can be increased. The uniformity of the electromagnetic wave absorption performance is a value expressed as a percentage of the ratio of the electromagnetic wave absorption performance at the folded portion to the electromagnetic wave absorption performance at the non-folded portions.

The display device 10 according to the first embodiment may be identical (or substantially identical) to the display device 10 described above with reference to FIG. 11. For example, the display device 10 according to the first embodiment may include the folding portion 710 having a lattice pattern structure. According to some embodiments, the uniformity of the electromagnetic wave absorption performance of the panel support layer 700 of the display device 10 according to the first embodiment may be 40% (or approximately 40%) or more when the hole area ratio of the lattice pattern is 50% (or approximately 50%). The hole area ratio refers to the ratio of the area occupied by the holes of the slits SLT to the total area of the folding portion 710

The display device 10 according to the second embodiment may be identical (or substantially identical) to the display device 10 described above with reference to FIG. 12. For example, the display device 10 according to the second embodiment may include the folding portion 710 having a stripe pattern structure. According to some embodiments, the uniformity of the electromagnetic wave absorption performance of the panel support layer 700 of the display device 10 according to the second embodiment may be 75% (or approximately 75%) or more when the hole area ratio of the stripe pattern is 20% (or approximately 20%).

In concluding the detailed description, those skilled in the art will appreciate that many variations and modifications can be made to the disclosed embodiments without substantially departing from the principles of the present invention. Therefore, the disclosed embodiments of the invention are used in a generic and descriptive sense only and not for purposes of limitation.

## Claims

1. A display device (10) comprising:
a display panel (400) comprising an emission material layer (EML) and a touch sensor layer (ISP) on the emission material layer (EML) and comprising a digitizer; and
a panel support layer (700) under the display panel (400),
wherein the panel support layer (700) comprises:
a first layer (701) comprising a first fiber (FT1) extending in a first direction (DR2),
a second layer (703) on the first layer (701) and comprising a second fiber (FT2) extending in a second direction (DR1) different from the first direction (DR2),
a third layer (705) on the second layer (703) and comprising the first fiber (FT1) extending in the first direction (DR2), and
a lower functional layer (707) comprising a magnetic metal powder.

2. The display device (10) of claim 1, further comprising:
a window (200) on a surface of the display panel (400), the surface is opposite to the side of the panel support layer (700);
a lower protective film (500) on an opposite surface of the display panel (400); wherein
the panel support layer (700) is under the lower protective film (500).

3. The display device (10) of claim 2, further comprising:
an upper protective film (100) on the window (200).

4. The display device (10) of at least one of claims 1 to 3, wherein the lower functional layer (707) is between the first layer (701) and the second layer (703), between the second layer (703) and the third layer (705), under the first layer (701), or on the third layer (705).

5. The display device (10) of at least one of claims 1 to 4, wherein the panel support layer (700) comprises: a folding portion (710) and at least one non-folding portion (720, 730) on one side of the folding portion (710), and
wherein the lower functional layer (707) is arranged across the folding portion (710) and the non-folding portion (720, 730).

6. The display device (10) of claim 5, wherein a thickness of the lower functional layer (707) at the folding portion (710) is equal to a thickness of the lower functional layer (707) at the non-folding portion (720, 730).

7. The display device (10) of claims 5 or 6, wherein the folding portion (710) comprises a lattice pattern, and
wherein a ratio of a coefficient of an electromagnetic wave absorption performance of the panel support layer (700) at the folding portion (710) to a coefficient of an electromagnetic wave absorption performance of the panel support layer (700) at the non-folding portion (720, 730) is equal to or greater than 40% and a hole area ratio is 50%.

8. The display device (10) of claims 5 or 6, wherein the folding portion (710) comprises a stripe pattern, and
wherein a ratio of a coefficient of an electromagnetic wave absorption performance of the panel support layer (700) at the folding portion (710) to a coefficient of an electromagnetic wave absorption performance of the panel support layer (700) at the non-folding portion (720, 730) is equal to or greater than 75% and a hole area ratio is 20%.

9. The display device (10) of at least one of claims 1 to 8, wherein the touch sensor layer (ISP) comprises a first sensing electrode (SE1) configured to recognize an input by an input device, and a second sensing electrode (SE2) configured to recognize a pressure by a user's touch.

10. The display device (10) of claim 9, further comprising:
a third sensing electrode between the first sensing electrode (SE1) and the second sensing electrode (SE2),
wherein the third sensing electrode is a ground electrode (GE).

11. The display device (10) of claim 10, wherein the first sensing electrode (SE1) and the second sensing electrode (SE2) are spaced apart from each other with the third sensing electrode interposed therebetween, and
wherein the first to third sensing electrodes (SE1, SE2) are insulated from one another.

12. A display device (10) comprising a folding area (FDA) and at least one non-folding area (NFA1, NFA2) on one side of the folding area (FDA), the display device (10) comprising:
a display panel (400) comprising an emission material layer (EML), and a touch sensor layer (ISP) on the emission material layer (EML) and comprising a touch electrode (TE) and a pen electrode (PE); and
a panel support layer (700) under the display panel (400) and comprising a first layer (701) and a second layer (703) comprising fiber yarns (FT1, FT2) extending in different directions (DR2, DR1), and an electromagnetic wave blocking layer (707) in the folding area (FDA) and the non-folding area (NFA1, NFA2).

13. The display device (10) of claim 12, wherein the electromagnetic wave blocking layer (707) is between the first layer (701) and the second layer (703), under the first layer (701), or on the second layer (703).

14. The display device (10) of claim 12 or 13, wherein the panel support layer (700) further comprises:
a third layer (705) comprising fiber yarn (FT1) extending in a different direction (DR1) from the second layer (703), and
wherein the first layer (701), the second layer (703), and the third layer (705) are stacked on one another sequentially.

15. The display device (10) of at least one of claims 12 to 14, wherein a thickness of the electromagnetic wave blocking layer (707) at the folding area (FDA) is equal to a thickness of the electromagnetic wave blocking layer (707) at the non-folding area (NFA1, NFA2).

16. The display device (10) of at least one of claims 12 to 15, wherein the panel support layer (700) comprises a lattice pattern in the folding area (FDA), and
wherein a ratio of a coefficient of absorption performance of the electromagnetic wave blocking layer (707) at the folding area (FDA) to a coefficient of absorption performance of the electromagnetic wave blocking layer (707) at the non-folding area (NFA1, NFA2) is equal to or greater than 40% and a hole area ratio is 50%.

17. The display device (10) of at least one of claims 12 to 15, wherein the panel support layer (700) comprises a stripe pattern in the folding area (FDA), and
wherein a ratio of a coefficient of absorption performance of the electromagnetic wave blocking layer (707) at the folding area (FDA) to a coefficient of absorption performance of the electromagnetic wave blocking layer (707) at the non-folding area (NFA1, NFA2) is equal to or greater than 40% and a hole area ratio is 20%.

18. The display device (10) of at least one of claims 12 to 17, wherein the pen electrode (PE) is configured to recognize an input by an input device, and the touch electrode (TE) is configured to recognize a pressure by a user's touch.

19. The display device (10) of at least one of claims 12 to 18, further comprising:
a ground electrode (GE) between the pen electrode (PE) and the touch electrode (TE).

20. The display device (10) of claim 19, wherein the pen electrode (PE) and the touch electrode (TE) are spaced apart from each other with the ground electrode (GE) interposed therebetween, and
wherein the pen electrode (PE), the touch electrode (TE) and the ground electrode (GE) are insulated from one another.

21. The display device (10) of at least one of claims 1 to 11, wherein the first fiber (FT1) and the second fiber (FT2) are polymers each containing carbon fiber or glass fiber, or of at least one of claims 12 to 20, wherein the fiber yarns (FT1, FT2) are polymers each containing carbon fiber or glass fiber.

22. An electronic device comprising
a display device (10) according to at least one of claims 1 to 21.

23. The electronic device of claim 22, wherein the electronic device is one of a mobile phone, a smart phone, a tablet PC, a smart watch, a watch phone, a mobile communications terminal, an electronic notebook, an electronic book, a portable multimedia player, PMP, a navigation device and a ultra mobile PC, UMPC, a television, a notebook, a monitor, a billboard, or an Internet of Things device.
